# EUROPEAN PATENT APPLICATION

(11) **EP 4 507 464 A1**
(43) Date of publication of application: **12.02.2025**
(21) Application number: 24192415.8
(22) Date of filing: 01.08.2024
(51) Int. Cl.: H05K 7/14, G06F 1/20, H05K 7/20, G06F 1/18

(54) **ELECTRONIC DEVICE AND IMMERSION COOLING SYSTEM**

(30) Priority: 11.08.2023 TW 112130317
(71) Applicant: Cooler Master Co., Ltd., Taipei City 114065 (TW)
(72) Inventor: HAUNG, YU-LUN, Taipei City (TW); CHANG, HUNG-WEI, Taipei City (TW)
(74) Representative: Grünecker Patent- und Rechtsanwälte PartG mbB

(57) **Abstract**

The invention pertains to an electronic device designed for efficient space utilization and ease of maintenance within immersion cooling systems. The device features a cage assembly comprising a fixed frame and two movable frames, each mounted with a motherboard. These movable frames can transition between open and closed positions. When closed, the expansion cards on the motherboards are arranged side by side to overlap, minimizing space usage. The unique configuration allows for convenient access and replacement of the expansion cards without interfering with the overall system setup.

## Description

### Technical Field

The present disclosure relates to an electronic device, more particularly to an electronic device configured for an immersion cooling system.

### Background

With the arrival of the big data era and the continuous development of cloud technology, the requirements for computing and processing units such as expansion cards are higher than ever, and the amount of the data needing to be processed is increasing. Accordingly, the density of heat transferring at the expansion cards rapidly increases, and heat generated thereby also increases massively. Therefore, the problem of heat dissipation needs to be solved urgently.

The expansion cards may be cooled by an immersion cooling system. For example, a motherboard provided with the expansion card is immersed into a coolant to cool the expansion cards so as to maintain the performance and prolong the lifespan of the expansion cards. However, a space of the immersion cooling system is narrow. When there are several expansion cards mounted on the motherboard, the overall size is increased. That is, the motherboard provided with the expansion cards may occupy most of the space of the immersion cooling system. Accordingly, the expansion cards disposed on the motherboard are difficult to be replaced in the narrow space of the immersion cooling system. Therefore, how to reduce the amount of space occupied by the motherboards provided with the expansion cards within the immersion cooling system is an important issue to be solved.

### SUMMARY

The present disclosure provides an electronic device according to claim 1 and an immersion cooling system according to claim 15 so as to reduce the amount of space occupied by the two motherboards provided with the expansion cards within the immersion cooling system.

One embodiment of the present disclosure provides an electronic device including a cage assembly, two motherboards and a plurality of expansion cards. The cage assembly includes a fixed frame and two movable frames. The two movable frame are movably disposed on the fixed frame so as to be movable from an open to a closed position (and preferably vice versa). Each motherboard is mounted on one of the movable frames. The plurality of expansion cards are mounted on the two motherboards. When the two movable frames are in the closed position, the plurality of expansion cards respectively located on the two motherboards are arranged side by side (preferably alternately) so as to overlap (preferably in the direction of movement of the movable frames, i.e. length of overlap measured parallel to a width direction of the expansion cards).

Another embodiment of the present disclosure provides an immersion cooling system including an immersion tank and at least one electronic device. The immersion tank is configured to accommodate a coolant. The at least one electronic device is disposed in the immersion tank, and includes a cage assembly, at least one motherboard and a plurality of expansion cards. The cage assembly includes a fixed frame and at least one movable frame. The at least one movable frame are movably disposed on the fixed frame. The at least one motherboard is mounted on the at least one movable frame, preferably on the side of the movable frame facing the interior of the cage assembly. The plurality of expansion cards are mounted on the at least one motherboard.

According to the electronic device and the immersion cooling system as described in the above embodiments, the at least one motherboard provided with the expansion cards is mounted on the two movable frames, such that the two motherboards provided with the expansion cards can be integrated with the cage assembly. Therefore, the amount of space occupied by the electronic device within the immersion cooling system can be reduced. In addition, the two movable frames can be moved relative to the fixed frame. When at least one movable frame is opened, the corresponding motherboard provided with the expansion cards can be moved along with the movable frame, such that the expansion cards can be replaced more conveniently.

In a further embodiment, one side of at least one of the two movable frames may be pivotally mounted on the fixed frame to allow another side of the respective movable frame to move closer to the fixed frame to be in a closed position of said respective movable frame or to move further away from said fixed frame to be in an open position of said respective movable frame. Preferably the angel of pivot movement is at least 60°, at best being substantially 90° (tolerance ± 10°). In the open position of the movable frame the expansion cards stand preferably upright (in width direction) on the inner side of the movable frame to gain easy access.

In a further embodiment, the cage assembly may have a top side and a bottom side and at least one pivot joint for pivotally mounting the respective movable frame, the at least one pivot joint is located near to the bottom side. Preferably, the pivot joint is located in the interior of the cage assembly to save space at the outside.

In a further embodiment, a pivot axis of the at least one pivot joint may extend substantially parallel to the bottom side of the cage assembly. If the cage assembly stands upright, the movable frame may be pivoted downwards and easy access on the expansion cards is gained from above.

In a further embodiment, the expansion cards may have a width and the length of the overlap in the direction perpendicular to the motherboards is at least 50%, preferably at least 75%, of said width. The length of overlap reflects the main benefit of saving space.

In a further embodiment, two pivot axis are provided that may extend parallel along the cage assembly in a distance and said distance may be in a range from 150% to 200% of the length of the overlap. Only little space is occupied by the motherboard(s), the connecting portions of the expansion cards and the pivot j oints. A major part of said distance can be used to locate the expansion cards.

In a further embodiment, the cage assembly has a width and the width may be less than 200% of the length of the overlap. An electronic device may be relatively small, but may contain a large number of expansion cards. Preferably the distance of the two pivot axis is less than the width of the cage assembly.

In a further embodiment, a plurality of fasteners are comprised, each of the plurality of fasteners comprising a first engagement portion and a second engagement portion, the plurality of first engagement portions being disposed on the fixed frame, the plurality of second engagement portions being disposed on at least one of the two movable frames, and the plurality of second engagement portions engaging the plurality of first engagement portions to secure the at least one movable frame to the fixed frame or to secure the at least one movable frame to the fixed frame in a closed position if the respective movable frame is pivotally mounted on the fixed frame.

In a further embodiment the at least one motherboard may comprise at least one conductive sheet, the at least one contact electrode has a first contact portion, and the first contact portion is electrically connected to the at least one conductive sheet.

In a further embodiment a seat is provided, wherein the at least one contact electrode has a second contact portion, the seat comprises a base and at least one conductive member, the cage assembly (preferably the bottom side) is detachably disposed on the base, the at least one conductive member is disposed on the base, the second contact portion is located in a distance from the first contact portion, and the second contact portion is electrically connected to the at least one conductive member. Preferably the at least one contact electrode is a conductive strip formed from sheet metal like a bus bar.

In a further embodiment, the at least one conductive member comprises a conductive strip and at least one conductive protrusion, the base has at least one through hole, the at least one conductive protrusion is connected to the conductive strip, the at least one conductive protrusion is disposed through the at least one through hole, and the second contact portion is electrically connected to the at least one conductive protrusion.

In a further embodiment, at least one cable organizer is comprised, wherein the at least one cable organizer is disposed on the at least one movable frame.

In a further embodiment, a handle is comprised, wherein the handle is disposed on the fixed frame, preferably at the top side of the cage assembly.

In a further embodiment, the plurality of expansion cards are graphics cards.

### BRIEF DESCRIPTION OF THE DRAWINGS

The present disclosure will become more fully understood from the detailed description given herein below and the accompanying drawings which are given by way of illustration only and thus are not limitative of the present disclosure and wherein:
FIG. 1 is a perspective view of an electronic device in accordance with a first embodiment of the present disclosure;
FIG. 2 is another perspective view of the electronic device in FIG. 1;
FIG. 3 is an exploded view of the electronic device in FIG. 2;
FIG. 4 is a perspective view of a seat of the electronic device in FIG. 1;
FIG. 5 is a cross-sectional view of the electronic device in FIG. 1;
FIG. 6 is a perspective view showing that two movable frames of the electronic device in FIG. 1 are in a closed position;
FIG. 7 is a perspective view showing that the two movable frames of the electronic device in FIG. 1 are in an open position; and
FIG. 8 is a perspective view of an immersion cooling system in accordance with a second embodiment of the present disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

In addition, the terms used in the present disclosure, such as technical and scientific terms, have its own meanings and can be comprehended by those skilled in the art, unless the terms are additionally defined in the present disclosure. That is, the terms used in the following paragraphs should be read on the meaning commonly used in the related fields and will not be overly explained, unless the terms have a specific meaning in the present disclosure.

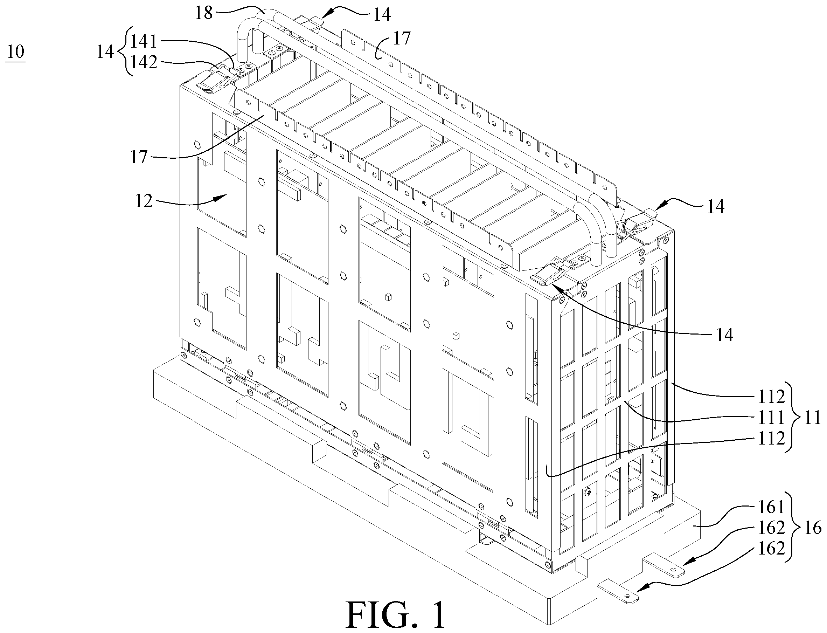

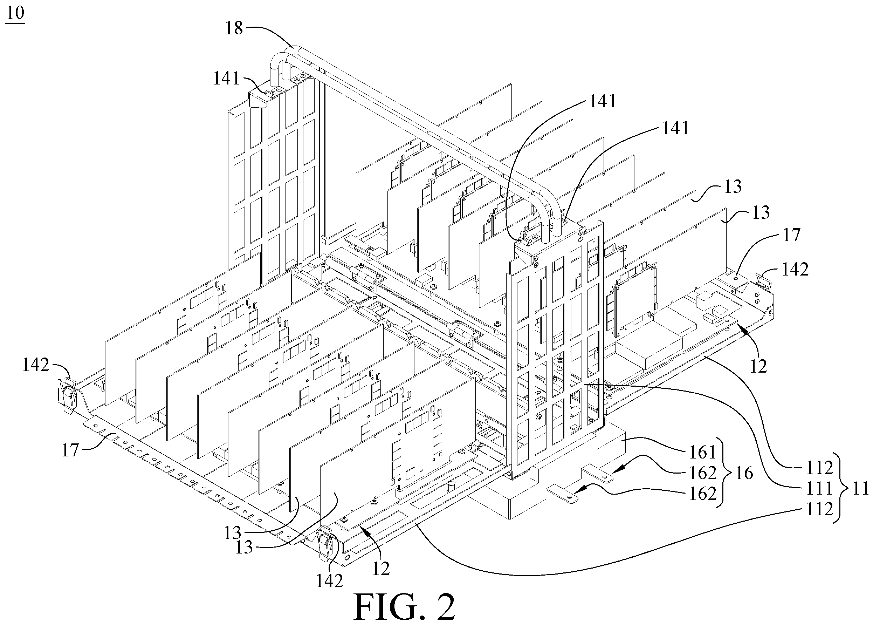

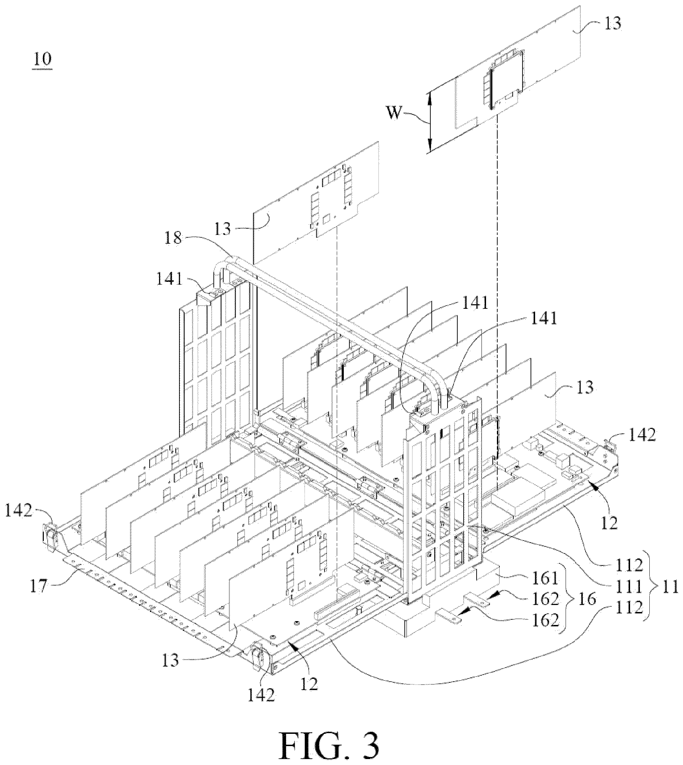

Please refer to FIG. 1 to FIG. 3, where FIG. 1 is a perspective view of an electronic device 10 in accordance with a first embodiment of the present disclosure, FIG. 2 is another perspective view of the electronic device 10 in FIG. 1, and FIG. 3 is an exploded view of the electronic device 10 in FIG. 2.

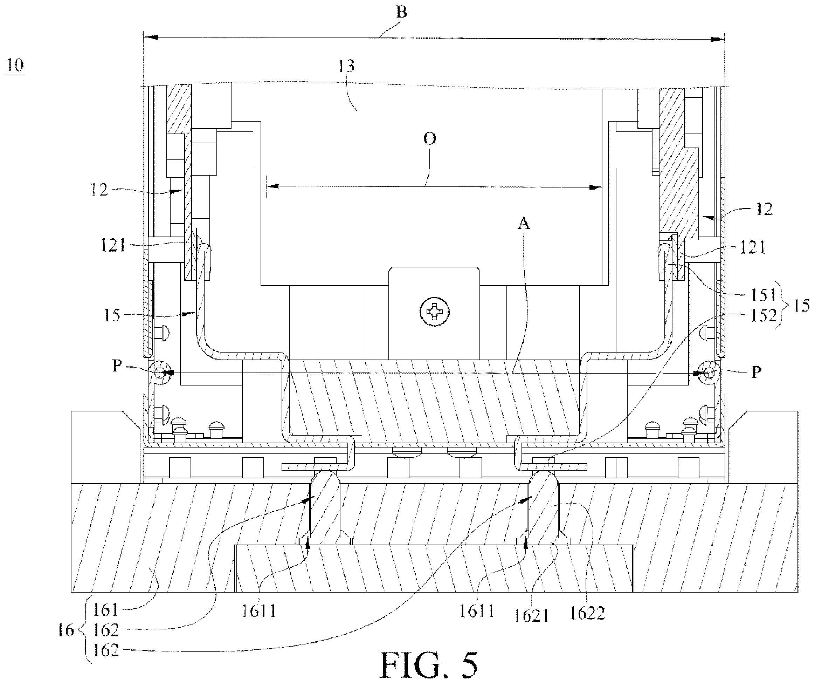

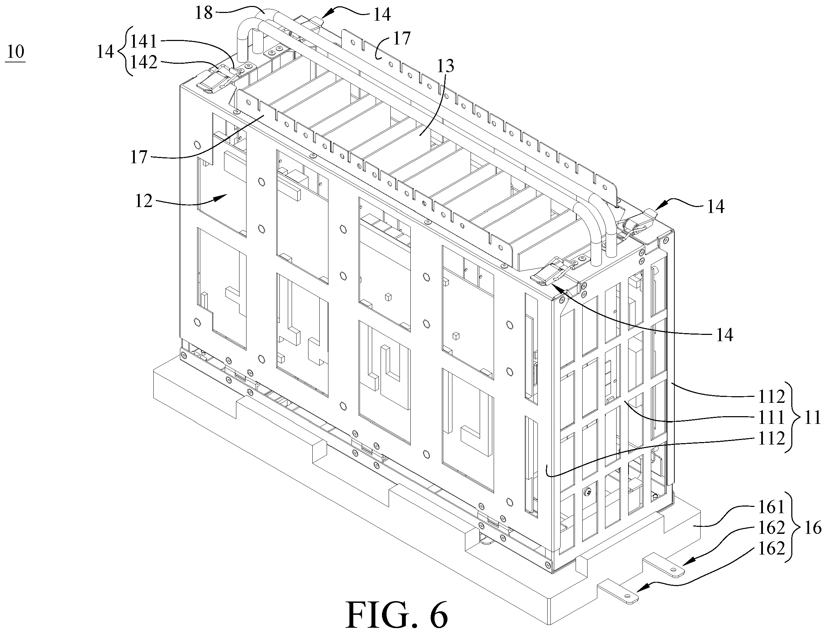

In this embodiment, the electronic device 10 includes a cage assembly 11, two motherboards 12, a plurality of expansion cards 13, a plurality of fasteners 14, a plurality of contact electrodes 15 (to be seen in FIG. 6) and a seat 16 (to be seen in FIG. 5 and FIG. 6). The cage assembly 11 includes a fixed frame 111 and two movable frames 112. One side (preferably the lower side in FIG. 1) of each of the two movable frames 112 is, for example, pivotally disposed on opposite sides of the fixed frame 111, enabling the other side of each of the two movable frames 112 to move closer to the fixed frame 111 for the two movable frames 112 to be in a closed position, or move relatively farther away from the fixed frame 111 for the two movable frames 112 to be in an open position (preferably the lower side of each movable frame 112 is pivotally connected to the fixed frame 111 by means of a pivot joint having a pivot axis P extending parallel to a bottom side of the cage assembly 11 (see FIG. 1 and 5)). When the two movable frames 112 are in the closed position, the two movable frames 112 stand upright (and are preferably parallel to each other). When the two movable frames 112 are in the open position, the two movable frames 112 lie flat (preferably lie in a common horizontal plane).

The two motherboards 12 are mounted on the two movable frames 112, respectively (and extend preferably parallel to the respective movable frame 112). The expansion cards 13 are, for example, graphics cards, and are mounted on the two motherboards 12, respectively (and extend preferably perpendicular to the respective motherboard 12). When the two movable frames 112 are in the closed position, the expansion cards 13 respectively disposed on the two motherboards 12 are arranged alternately without interfering with each other (preferably overlap each other by an overlap length O of approx. 80 % of their respective dimension (e.g. the width W of the expansion cards 13). The expansion cards 13 are located parallel to each other with a reasonable gap there between to provide for sufficient cooling.

Each fastener 14 includes a first engagement portion 141 and a second engagement portion 142. The first engagement portions 141 are disposed on the fixed frame 111. The second engagement portions 142 are disposed on the two movable frames 112. The second engagement portions 142 can be engaged with the first engagement portions 141 to secure the two movable frames 112 to the fixed frame 111 when the two movable frames 112 are in the closed position. Accordingly, the two motherboards 12 provided with the expansion cards 13 can be integrated with the cage assembly 11 (preferably lie completely within the outer boundary of the cage assembly 11).

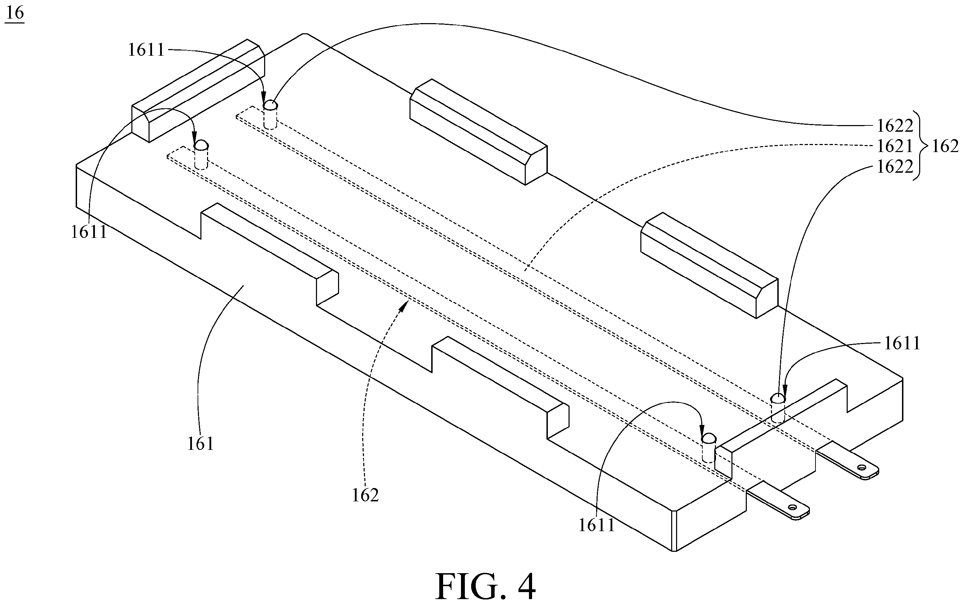

Please refer to FIG. 1 to FIG. 5, where FIG. 4 is a perspective view of the seat 16 of the electronic device 10 in FIG. 1, and FIG. 5 is a cross-sectional view of the electronic device 10 in FIG. 1

Each motherboard 12 includes a plurality of conductive sheets 121. Each contact electrode 15 has a first contact portion 151 (preferably extending vertically) and a second contact portion 152 (preferably extending horizontally). The second contact portions 152 are located relatively far away from the first contact portions 151 (are preferably offset in vertical and horizontal direction). The first contact portions 151 are electrically connected to the conductive sheets 121, respectively, if the respective movable frame 112 is in a closed position. The seat 16 includes a base 161 and a plurality of (preferably two parallel) conductive members 162. The cage assembly 11 is detachably disposed on the base 161 (preferably centered thereon by respective positioning means). The conductive members 162 are disposed on the base 161 (preferably running along the central portion thereof in parallel and attached from a bottom side of the base 161). The second contact portions 152 are electrically connected to the conductive members 162, respectively (preferably permanently if assembled that means in the open and closed position of the respective movable frame 112).

Specifically, each conductive member 162 includes a conductive strip 1621 (located in a groove at the bottom side of the base 161) and a plurality of (preferably four) conductive protrusions 1622 (preferably extending through the bottom of the base 161). The base 161 has a plurality of through holes 1611. The conductive protrusions 1622 are connected to the conductive strip 1621. The conductive protrusions 1622 are disposed through the through holes 1611, respectively, and preferably protrude from a top side of the base 161. The second contact portions 152 are electrically connected to the conductive protrusions 1622 of the conductive members 162, respectively. The first contact portions 151 and the second contact portions 152 of the contact electrodes 15 are electrically connected to the conductive sheets 121 of the two motherboards 12 and the conductive protrusions 1622 of the conductive members 162, respectively, enabling the transfer of power and signals.

In this embodiment, the electronic device 10 may further include two cable organizers 17 (preferably disposed on the upper side of the movable frame 112 opposite the pivot joint). The two cable organizers 17 are disposed on the two movable frames 112, respectively, such that cables (not shown) plugged into the electronic device 10 can be accommodated in the two cable organizers 17 to prevent them from getting disorganized.

In this embodiment, the electronic device 10 may further include a handle 18. The handle 18 is disposed on the fixed frame 111, allowing for convenient portability.

In this embodiment, the advantage of respectively installing the two motherboards 12 provided with the expansion cards 13 on the two movable frames 112 is that since the two motherboards 12 provided with the expansion cards 13 can be integrated with the cage assembly 11 (preferably located completely inside the cage assembly 11), the amount of space occupied by the electronic device 10 within an immersion cooling system can be reduced. The cage assembly 11 having a width B in the closed position of the movable frames 112 and the picot axes P of the pivot j oints have a distance A that is less than the width B. In the closed position the pivot joints are located in the interior of the cage assembly 11. In addition, when the two movable frames 112 are opened, the two motherboards 12 provided with the expansion cards 13 can be moved along with the two movable frames 112, such that the expansion cards 13 can be replaced more conveniently (preferably the expansion cards 13 stand upright on the respective motherboard 12 in the open position of the respective movable frame 112 and each expansion card 13 might be easily detached from the respective motherboard 12 by simply lifting it therefrom).

In this embodiment, the cage assembly 11 includes two movable frames 112, and the electronic device 10 includes two motherboards 12, but the present disclosure is not limited thereto. In other embodiments, the cage assembly may include one movable frame merely, and the electronic device may include one motherboard merely.

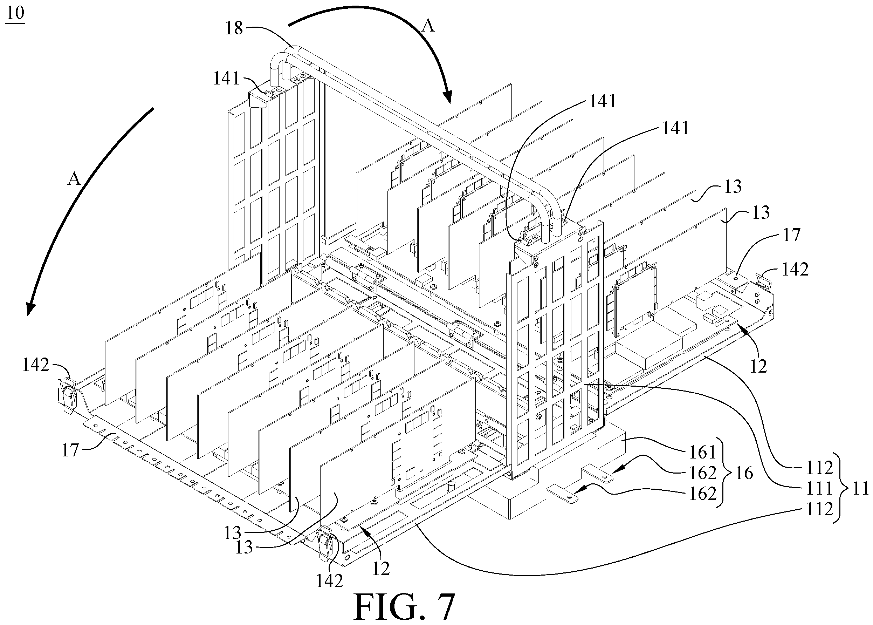

Please refer to FIG. 6 and FIG. 7, where FIG. 6 is a perspective view showing that the two movable frames 112 of the electronic device 10 in FIG. 1 are in the closed position, and FIG. 7 is a perspective view showing that the two movable frames 112 of the electronic device 10 in FIG. 1 are in the open position.

As shown in FIG. 6, the two movable frames 112 are in the closed position. The second engagement portions 142 are engaged with the first engagement portions 141 to secure the two movable frames 112 provided with the two motherboards 12 to the fixed frame 111. At this time, the two motherboards 12 provided with the expansion cards 13 can be integrated with the cage assembly 11. Therefore, when the electronic device 10 is disposed in the immersion cooling system, the amount of space occupied by the electronic device 10 can be reduced.

As shown in FIG. 7, when the expansion cards 13 need to be replaced, the second engagement portions 142 are firstly released from the first engagement portions 141, and the two movable frames 112 are rotated along a direction A to be opened (and about the pivot axis P of the respective pivot joint), respectively, such that the two movable frames 112 are moved from the closed position to the open position. At this time, the two motherboards 12 provided with the expansion cards 13 are also moved along with the two movable frames 112 to the open position, such that the expansion cards 13 can be replaced more conveniently. When the replacement of the expansion cards 13 is finished, the two movable frames 112 are rotated along a direction opposite to the direction A to be closed (about the pivot axis P of the respective pivot joint ), respectively, such that the two movable frames 112 are moved from the open position to the closed position. Then, the second engagement portions 142 are engaged with the first engagement portions 141 again to secure the two movable frames 112 to the fixed frame 111.

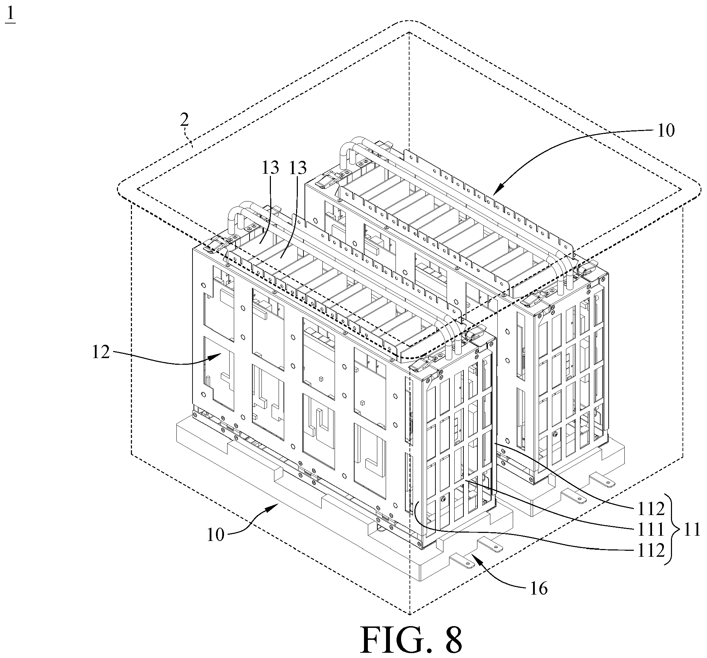

Please refer to FIG. 8, which is a perspective view of an immersion cooling system 1 in accordance with a second embodiment of the present disclosure. In this embodiment, the immersion cooling system 1 includes an immersion tank 2 and a plurality of (preferably two) electronic devices 10. The immersion tank 2 is configured to accommodate a coolant (not shown). The electronic devices 10 are disposed in the immersion tank 2, and are cooled by the coolant.

Specifically, each electronic device 10 includes a cage assembly 11, two motherboards 12, a plurality of expansion cards 13 and a seat 16. The cage assembly 11 is detachably disposed on the seat 16, and includes a fixed frame 111 and two movable frames 112. One side of each of the two movable frames 112 is, for example, pivotally disposed on the fixed frame 111 so that the two movable frames 112 are pivotally disposed on opposite sides of the fixed frame 111.. The two motherboards 12 are mounted on the two movable frames 112, respectively. The expansion cards 13 are, for example, graphics cards, and are mounted on the two motherboards 12, respectively (preferably by means of a socket and plug engagement).

When the expansion cards 13 disposed in the electronic devices 10 require replacement, the cage assembly 11 can be detached from the seat 16 and removed from the immersion tank 2, which enables convenient replacement of the expansion cards 13 in a more spacious environment, avoiding the complexities of performing replacements within a confined space of the immersion tank 2.

In this embodiment, the immersion cooling system 1 includes the plurality of electronic devices 10, but the present disclosure is not limited thereto. In other embodiments, the immersion cooling system may include one electronic device merely.

According to the electronic device and the immersion cooling system as described in the above embodiments, the two motherboards provided with the expansion cards are mounted on the two movable frames, respectively, such that the two motherboards provided with the expansion cards can be integrated with the cage assembly. Therefore, the amount of space occupied by the electronic device within the immersion cooling system can be reduced. In addition, the two movable frames can be moved relative to the fixed frame. When the two movable frames are opened, the two motherboards provided with the expansion cards can be moved along with the two movable frames, such that the expansion cards can be replaced more conveniently.

It will be apparent to those skilled in the art that various modifications and variations can be made to the present disclosure. It is intended that the specification and examples be considered as exemplary embodiments only, with a scope of the present disclosure being indicated by the claims.

## Claims

1. An electronic device (10), comprising:
a cage assembly (11), comprising a fixed frame (111) and two movable frames (112), wherein the two movable frames (112) are movably mounted on the fixed frame (111) so as to be movable from an open to a closed position;
two motherboards (12), wherein a motherboard (12) is mounted on each of the movable frames (112), the two movable frames (112) each provided with one of the motherboards (12) being disposed on two opposite sides of the fixed frame (111) ; and
a plurality of expansion cards (13), mounted on each of the motherboards (12), wherein, when the two movable frames (112) are in the closed position, the plurality of expansion cards (13) respectively located on the two motherboards (12) are arranged side by side so as to overlap.

2. The electronic device (10) according to claim 1, wherein one side of at least one of the two movable frames (112) is pivotally mounted on the fixed frame (111) to allow another side of the respective movable frame (112) to move closer to the fixed frame (111) to be in a closed position of said respective movable frame (112) or to move further away from said fixed frame (111) to be in an open position of said respective movable frame (112).

3. The electronic device (10) according to claim 2, wherein the cage assembly (11) has a top side and a bottom side and at least one pivot joint for pivotally mounting the respective movable frame (112), the at least one pivot joint is located near to the bottom side.

4. The electronic device (10) according to claim 3, wherein a pivot axis (P) of the at least one pivot joint extents substantially parallel to the bottom side of the cage assembly.

5. The electronic device (10) according to one of claims 1 to 4, wherein the expansion cards (13) have a width (W) and that the length of the overlap (O) in the direction perpendicular to the motherboards (12) is at least 50% of the width (W).

6. The electronic device (10) according to claim 3 or 4, wherein two pivot axis (P) extend parallel along the cage assembly (11) in a distance (A) and that said distance (A) is in a range from 150% to 200% of the length of the overlap (O).

7. The electronic device (10) according to one of claims 1 to 6, wherein the cage assembly has a width (B) and that the width (B) is less than 200% of the length of the overlap (O).

8. The electronic device (10) according to one of claims 1 to 7, further comprising a plurality of fasteners (14), each of the plurality of fasteners (14) comprising a first engagement portion (141) and a second engagement portion (142), the plurality of first engagement portions (141) being disposed on the fixed frame (111), the plurality of second engagement portions (142) being disposed on at least one of the two movable frames (112), and the plurality of second engagement portions (142) engaging the plurality of first engagement portions (141) to secure the at least one movable frame (112) to the fixed frame (111) or to secure the at least one movable frame (112) to the fixed frame (111) in a closed position if the respective movable frame (112) is pivotally mounted on the fixed frame (111).

9. The electronic device (10) according to one of claims 1 to 8, further comprising at least one contact electrode (15), wherein the at least one motherboard (12) comprises at least one conductive sheet (121), the at least one contact electrode (15) has a first contact portion (151), and the first contact portion (151) is electrically connected to the at least one conductive sheet (121).

10. The electronic device (10) according to claim 9, further comprising a seat (16), wherein the at least one contact electrode (15) has a second contact portion (152), the seat (16) comprises a base (161) and at least one conductive member (162), the cage assembly (11) is detachably disposed on the base (161), the at least one conductive member (162) is disposed on the base (161), the second contact portion (152) is located in a distance from the first contact portion (151), and the second contact portion (152) is electrically connected to the at least one conductive member (162).

11. The electronic device (10) according to claim 10, wherein the at least one conductive member (162) comprises a conductive strip (1621) and at least one conductive protrusion (1622), the base (161) has at least one through hole (1611), the at least one conductive protrusion (1622) is connected to the conductive strip (1621), the at least one conductive protrusion (1622) is disposed through the at least one through hole (1611), and the second contact portion (152) is electrically connected to the at least one conductive protrusion (1622).

12. The electronic device (10) according to one of claims 1 to 11, further comprising at least one cable organizer (17), wherein the at least one cable organizer (17) is disposed on the at least one movable frame (112).

13. The electronic device (10) according to one of claims 1 to 12, further comprising a handle (18), wherein the handle (18) is disposed on the fixed frame (111).

14. The electronic device (10) according to one of claims 1 to 13, wherein the plurality of expansion cards (13) are graphics cards.

15. An immersion cooling system (1), comprising:
an immersion tank (2), configured to accommodate a coolant; and
at least one electronic device (10) according to one of claims 1 to 14, disposed in the immersion tank (2).
